# EUROPÄISCHE PATENTSCHRIFT

(11) **EP 4 075 488 B1**
(45) Veröffentlichungstag und Bekanntmachung des Hinweises auf die Patenterteilung: **28.02.2024**
(21) Anmeldenummer: 21167990.7
(22) Anmeldetag: 13.04.2021
(51) Int. Cl.: H01L 21/68

(54) **VERFAHREN ZUM HERSTELLEN VON HALBLEITERSCHEIBEN MIT AUS DER GASPHASE ABGESCHIEDENER EPITAKTISCHER SCHICHT IN EINER ABSCHEIDEKAMMER**
METHOD FOR MANUFACTURING SEMICONDUCTOR WAFERS HAVING AN EPITAXIAL LAYER DEPOSITED FROM THE GAS PHASE IN A DEPOSITION CHAMBER
PROCÉDÉ DE FABRICATION DE PLAQUETTES SEMI-CONDUCTRICES À COUCHE ÉPITAXIALE DÉPOSÉE EN PHASE GAZEUSE DANS UNE CHAMBRE DE DÉPÔT

(43) Veröffentlichungstag der Anmeldung: 19.10.2022
(73) Patentinhaber: Siltronic AG, 81677 München (DE)
(72) Erfinder: Stettner, Thomas, 83329 Waging am See (DE)
(74) Vertreter: Staudacher, Wolfgang

(56) Entgegenhaltungen:
- JP-B2- 5 704 461
- US-A1- 2006 086 462

## Beschreibung

Gegenstand der Erfindung ist ein Verfahren zum Herstellen von Halbleiterscheiben mit aus der Gasphase abgeschiedener epitaktischer Schicht in einer Abscheidekammer. Halbleiterscheiben mit epitaktischer Schicht werden zur Herstellung elektronischer Bauelemente benötigt. Das Abscheiden der epitaktischen Schicht findet üblicherweise in einer Abscheidekammer statt, die als Einzelscheiben-Reaktor ausgebildet ist. Die zu beschichtende Substratscheibe wird auf einem Suszeptor abgelegt, und ein Abscheidegas bei einer Abscheidetemperatur durch die Abscheidekammer über die sich mit dem Suszeptor drehende Substratscheibe geleitet.

Ein Qualitätskriterium von Halbleiterscheiben mit epitaktischer Schicht ist die Gleichförmigkeit der Dicke der epitaktischen Schicht, insbesondere im Randbereich der Halbleiterscheibe.

### Stand der Technik / Probleme

WO 2017 102 597 A1 widmet sich insbesondere der Aufgabe, die Randgeometrie einer Halbleiterscheibe mit epitaktischer Schicht zu verbessern. Es wurde festgestellt, dass nach einer üblicherweise regelmäßig durchgeführten Ätze der Abscheidekammer (Kammerätze), um Material zu entfernen, das sich im Verlauf vorangegangener Beschichtungsvorgänge in der Abscheidekammer niedergeschlagen hat, ein Randabfall bei nachfolgend in der Abscheidekammer erzeugten Halbleiterscheiben mit epitaktischer Schicht von Beschichtungsvorgang zu Beschichtungsvorgang zunimmt.

In JP 2016 213 218 A ist ein Verfahren zur Herstellung von Halbleiterscheiben aus einkristallinem Silizium mit epitaktischer Schicht aus einkristallinem Silizium beschrieben. Es wird empfohlen, dass ein Roboter, der die Substratscheibe auf den Suszeptor eines Abscheide-Reaktors ablegt, zu einer Ablageposition bewegt wird, in der das Zentrum der Substratscheibe wegen einer Korrekturvorgabe nicht über dem Zentrum des Suszeptors liegt. Es wurde herausgefunden, dass andernfalls die Substratscheiben während des Abscheidens der epitaktischen Schicht im statistischen Mittel nicht zentriert auf dem Suszeptor liegen. Liegt die Substratscheibe während des Abscheidens der epitaktischen Schicht nicht konzentrisch in der Tasche des Suszeptors, hat das eine nachteilige Auswirkung auf die Gleichförmigkeit der Dicke epitaktischen Schicht. Darüber hinaus kann eine solche Fehllage eine unerwünschte Bildung von Partikeln zur Folge haben, insbesondere wenn dadurch ein Kontakt des Rands der Substratscheibe mit dem Suszeptor einhergeht. Die Korrekturvorgabe wird von einem Mittelwert abgeleitet, der die mittlere Abweichung der Lage des Zentrums von Substratscheiben vom Zentrum des Suszeptors während vorangegangener Beschichtungsvorgänge beschreibt. Mit der Korrekturvorgabe ist die Erwartung verknüpft, während eines Beschichtungsvorgangs eine Lage des Zentrums der Substratscheibe zu erreichen, die um den Betrag der mittleren Abweichung näher am Zentrum des Suszeptors ist, als wenn auf die Korrekturvorgabe verzichtet werden würde.

US 2006/086462 A1 ist ein Verfahren zum Herstellen von Halbleiterscheiben aus dem Stand der Technik.

Der Erfinder der vorliegenden Erfindung hat festgestellt, dass ein Festlegen der Korrekturvorgabe, das sich allein an der Lageabweichung von Substratscheiben während vorangegangener Beschichtungsvorgänge orientiert, verbesserungswürdig ist.

Die Aufgabe der Erfindung wird gelöst durch ein Verfahren zum Herstellen von Halbleiterscheiben mit aus der Gasphase abgeschiedener epitaktischer Schicht in einer Abscheidekammer, umfassend
das Entfernen von Material aus der Abscheidekammer, das sich im Verlauf vorangegangener Beschichtungsvorgänge in der Abscheidekammer niedergeschlagen hat, mittels einer Ätze der Abscheidekammer;
nacheinander durchgeführte Beschichtungsvorgänge in der geätzten Abscheidekammer, jeweils umfassend
das Ablegen einer Substratscheibe auf einem Suszeptor mit kreisförmigem Umfang durch einen Roboter, wobei der Roboter die Substratscheibe in eine Ablageposition bewegt und auf dem Suszeptor ablegt, wobei in der Ablageposition das Zentrum der Substratscheibe wegen einer Korrekturvorgabe nicht über dem Zentrum des Suszeptors liegt; und
das Abscheiden einer epitaktischen Schicht auf der Substratscheibe, wobei eine Halbleiterscheibe mit epitaktischer Schicht entsteht, dadurch gekennzeichnet, dass für jede erste Substratscheibe, die nach der Ätze der Abscheidekammer vom Roboter in die Ablageposition bewegt wird, der Betrag der Korrekturvorgabe einem Mittelwert von Lageabweichungen einer Anzahl zuvor beschichteter Substratscheiben entspricht, die selbst jeweils als erste nach einer vorangegangenen Kammerätze beschichtet wurden.

Vor dem ersten Beschichtungsvorgang nach einer Kammerätze befindet sich die Abscheidekammer in einem Zustand, in dem eintreffende Strahlungsenergie einen schnelleren Temperaturanstieg bewirkt, als vor den zweiten und folgenden Beschichtungsvorgängen. Das hat zur Folge, dass die zu erwartende Fehllage der Substratscheibe insbesondere für die erste Substratscheibe nach einer Kammerätze ausgeprägter ist, als für Substratscheiben, die danach beschichtet werden.

Es wird daher vorgeschlagen, zur Berechnung der Korrekturvorgabe für die erste, nach einer Kammerätze zu beschichtende Substratscheibe nur Lageabweichungen von Substratscheiben vorangegangener Beschichtungsvorgänge zu berücksichtigen, die für Substratscheiben gemessen wurden, die selbst jeweils die erste Substratscheibe nach einer Kammerätze waren. Solche Substratscheiben werden nachfolgend Substratscheiben der ersten Kategorie genannt. Die Korrekturvorgabe wird durch Mittelung der Lageabweichungen berechnet. Der Begriff Lageabweichung beschreibt die Abweichung der Position des Zentrums einer abgelegten Substratscheibe relativ zum Zentrum des Suszeptors.

Vorzugsweise werden die Lageabweichungen von mindestens 3 Substratscheiben der ersten Kategorie, besonders bevorzugt die Lageabweichungen von 5 bis 10 solcher Substratscheiben zur Berechnung des Mittelwerts (arithmetisches Mittel) verwendet. Vorzugsweise sind die Kammerätzen, die den Substratscheiben der ersten Kategorie jeweils vorausgegangen sind, selbst derjenigen Kammerätze unmittelbar vorausgegangen, nach der die Beschichtung der zu beschichtenden ersten Substratscheibe folgt.

Es ist grundsätzlich möglich, für jede Kategorie von Substratscheiben eine eigene Korrekturvorgabe nach dem Vorbild der Substratscheiben der ersten Kategorie zu berechnen. In der Regel reicht es aber aus, für Substratscheiben, die nicht die Ersten nach einer Kammerätze sind, eine Korrekturvorgabe zu berechnen, die auf Lageabweichungen von Substratscheiben vorangegangener anderer Beschichtungsvorgänge beruht, die nicht erste Beschichtungsvorgänge nach einer Kammerätze waren.

Substratscheiben, auf denen eine epitaktische Schicht erfindungsgemäß abgeschieden wird, sind Halbleiterscheiben, die einen Dotierstoff enthalten, vorzugsweise Substratscheiben aus einkristallinem Silizium.

Die Erfindung wird nachfolgend mit Verweis auf Zeichnungen näher beschrieben.

### Kurzbeschreibung der Figuren

**Fig. 1** zeigt in Schittdarstellung eine Vorrichtung zum Abscheiden einer epitaktischen Schicht aus der Gasphase auf eine Substratscheibe mit dafür typischen Merkmalen.
**Fig. 2** zeigt die Positionen eines ersten und zweiten Mittelwerts von Lageabweichungen von Substratscheiben der ersten Kategorie und einer anderen Kategorie relativ zum Zentrum des Suszeptors.
**Fig. 3** zeigt die Verteilung der Zentren von Substratscheiben der ersten Kategorie nach dem Ablegen auf dem Suszeptor relativ zum Zentrum des Suszeptors in einem Polarkoordinaten-Gitter.
**Fig. 4** zeigt die Verteilung der Zentren von Substratscheiben einer anderen Kategorie nach dem Ablegen auf dem Suszeptor relativ zum Zentrum des Suszeptors in einem Polarkoordinaten-Gitter.

### Liste der verwendeten Bezugszeichen

- **1**: oberer Deckel
- **2**: unterer Deckel
- **3**: Abscheidekammer
- **4**: Substratscheibe
- **5**: Suszeptor
- **6**: Vorheizring
- **7**: obere Auskleidung
- **8**: untere Auskleidung
- **9**: obere Gaseintrittsöffnungen
- **10**: Zentrum des Suszeptors
- **11**: oberer Gasauslass
- **12**: untere Gaseintrittsöffnungen
- **13**: unterer Gasauslass
- **14**: zweite mittlere Position des Zentrums abgelegter Substratscheiben
- **15**: erste mittlere Position des Zentrums abgelegter Substratscheiben
- **16**: Vektor
- **17**: Vektor

### Detaillierte Beschreibung erfindungsgemäßer Ausführungsbeispiele

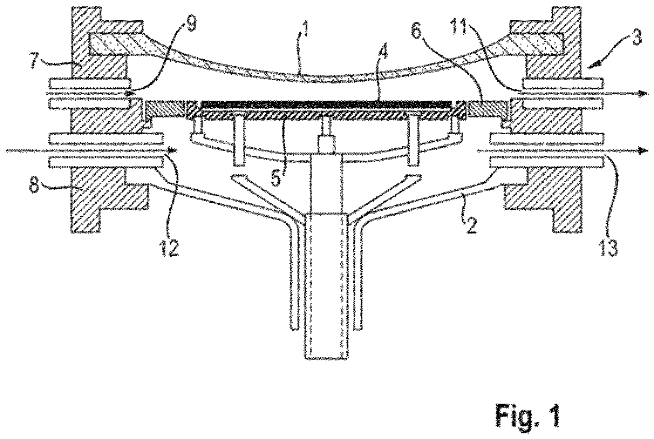

Die in Fig.1 dargestellte Vorrichtung zum Abscheiden einer epitaktischen Schicht auf einer Substratscheibe umfasst eine Abscheidekammer 3 mit einem oberen Deckel 1 und einem unteren Deckel 2 und obere und untere Auskleidungen 7 und 8, die einen Reaktionsraum umschließen. Außerhalb der Abscheidekammer 3 vorhandene obere und untere Lampenbänke sind nicht dargestellt. Mittels der Strahlungsenergie der Lampen wird die Abscheidekammer auf die Temperatur gebracht, die für die Gasphasenabscheidung notwendig ist.

Für einen Beschichtungsvorgang wird eine Substratscheibe 4 auf einem Suszeptor 5 abgelegt, der von unten durch Arme eines Trägers drehbar gehalten wird. Zuvor wird die Substratscheibe auf einen Endeffektor eines Roboters gelegt und vom Roboter zu einer Ablageposition bewegt. Um den Suszeptor herum ist ein Vorheizring 6 angeordnet. Die Substratscheibe 4 kann mittels Hebestiften, die durch den Suszeptor 5 durchgeführt sind, auf dem Suszeptor 5 abgelegt und nach dem Beschichten vom Suszeptor 5 weggehoben werden.

Beim Beschichten der Substratscheibe 4 wird Abscheidegas durch obere Gaseintrittsöffnungen 9, die in der oberen Auskleidung 7 vorgesehen sind, in die Abscheidekammer 3 entlang einer Strömungsrichtung über die Substratscheibe zu einem oberen Gasauslass 11 gleitet. Darüber hinaus können optional untere Gaseintrittsöffnungen 12 und ein unterer Gasauslass 13 vorgesehen sein, um ein Spülgas unter dem Suszeptor 5 hindurch zum unteren Gasauslass 13 zu leiten.

Wird die Ablageposition für den Roboter derart eingestellt, dass das Zentrum der Substratscheibe senkrecht über dem Zentrum des Suszeptors liegt, besteht eine vergleichsweise hohe Wahrscheinlichkeit, dass nach der Ablage der Substratscheibe deren Zentrum nicht im Zentrum des Suszeptors liegt. Der Grund dafür sind insbesondere thermische Spannungen, die sich lösen, wodurch das Zentrum der Substratscheibe aus der vorgesehenen Lage verschoben wird.

Es wurde nun herausgefunden, dass der Betrag der Verschiebung vom Zentrum des Suszeptors umso größer ist, je geringer die Anzahl an Beschichtungsvorgängen ist, die seit der letzten Kammerätze absolviert wurden. Erfindungsgemäß wird diese Erkenntnis bei der Berechnung der Korrekturvorgabe berücksichtigt, die die Ablageposition mitbestimmt, in die der Roboter eine Substratscheibe vor deren Ablage auf den Suszeptor bewegt. Die Korrekturvorgabe wird für die jeweils erste Substratscheibe, die nach einer Kammerätze beschichtet werden soll, durch Mittelung von Lageabweichungen zuvor beschichteter Substratscheiben berechnet, wobei zur Berechnung nur Lageabweichungen von Substratscheiben der ersten Kategorie herangezogen werden, also von Substratscheiben, die jeweils selbst als erste nach einer Kammerätze beschichtet wurden.

Ohne die vorgeschlagene, auf die Zugehörigkeit zur ersten Kategorie abstellende Mittelung würde mittels unspezifischer Mittelung von Lageabweichungen eine Korrekturvorgabe resultieren, die weniger genau wäre, weil die besondere Ausprägung der Lageabweichung unmittelbar nach einer Kammerätze herausgemittelt würde. Die Korrekturvorgabe sollte jedoch möglichst genau sein, weil sich eine zentrierte Lage der Substratscheibe auf dem Suszeptor vorteilhaft auf die Randgeometrie der resultierenden Halbleiterscheibe mit epitaktischer Schicht auswirkt und auch das Risiko abnimmt, dass während des Abscheidens der epitaktischen Schicht Partikel erzeugt werden.

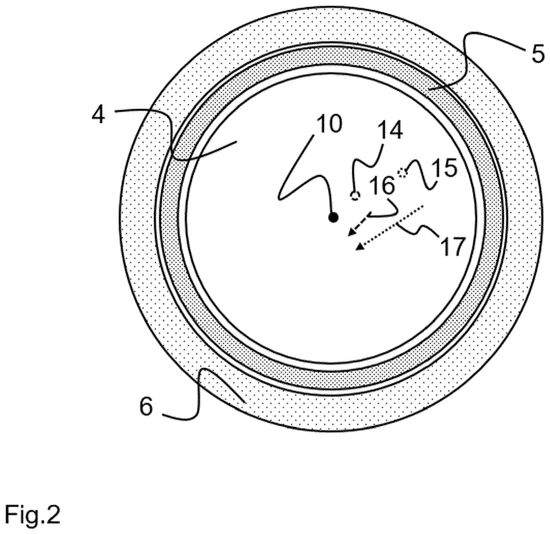

Fig.2 zeigt eine Substratscheibe 4, die auf einem Suszeptor 5 abgelegt ist, so dass das Zentrum 10 des Suszeptors 5 und das Zentrum der Substratscheibe 4 zusammenfallen. In dieser Zielposition liegt die Substratscheibe 4 konzentrisch zum Suszeptor 5 und zum Vorheizring 6. Ohne eine Korrekturvorgabe würde das Zentrum der Substratscheibe abhängig von der Zugehörigkeit zur ersten oder einer anderen Kategorie auf oder in der Nähe derjenigen mittleren Position liegen, die für diese Kategorie berechnet wurde, beispielsweise auf oder in der Nähe der ersten mittleren Position 15 im Fall der Zugehörigkeit zur ersten Kategorie oder auf oder in der Nähe der zweiten mittleren Position 14 im Fall zur Zugehörigkeit zu einer anderen Kategorie. In der Zeichnung sind die Positionen 14 und 15 unrealistisch weit vom Zentrum 10 des Suszeptors entfernt platziert, um die Erfindung darstellen zu können. Tatsächlich haben übliche Lageabweichungen einen Abstand von nicht mehr als 1000 µm vom Zentrum 10 des Suszeptors.

Die erste mittlere Position 15 hat einen Abstand zum Zentrum 10 des Suszeptors 5, der der Länge des Vektors 17 entspricht. Die zweite mittlere Position 14 hat einen Abstand zum Zentrum 10 des Suszeptors 5, der der Länge des Vektors 16 entspricht. Wird der Vektor 16 beziehungsweise der Vektor 17 verschoben, so dass sein Anfang mit dem Zentrum 10 des Suszeptors zusammenfällt, zeigt die Spitze des Vektors zur Ablageposition, in die der Roboter die Substratscheibe mit ihrem Zentrum bewegen muss, damit eine zu erwartende Lageabweichung kompensiert wird. Der Vektor 17 repräsentiert also die Korrekturvorgabe für den Roboter in Bezug auf die erste, nach einer Kammerätze zu beschichtende Substratscheibe, der Vektor 16 die Korrekturvorgabe für den Roboter in Bezug auf Substratscheiben anderer Kategorien.

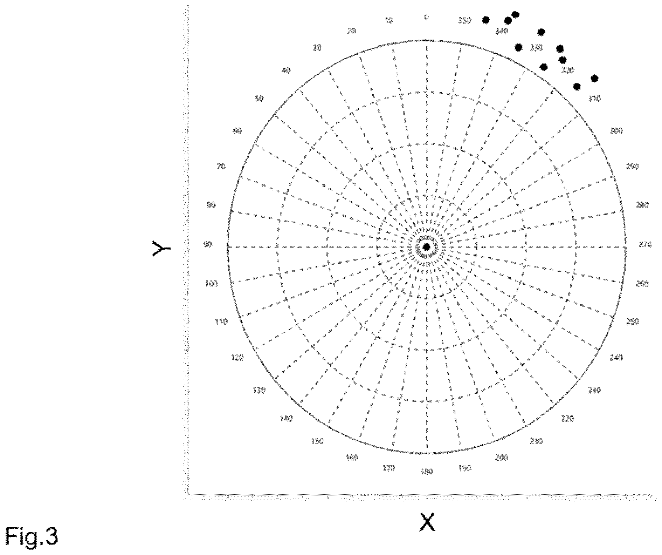

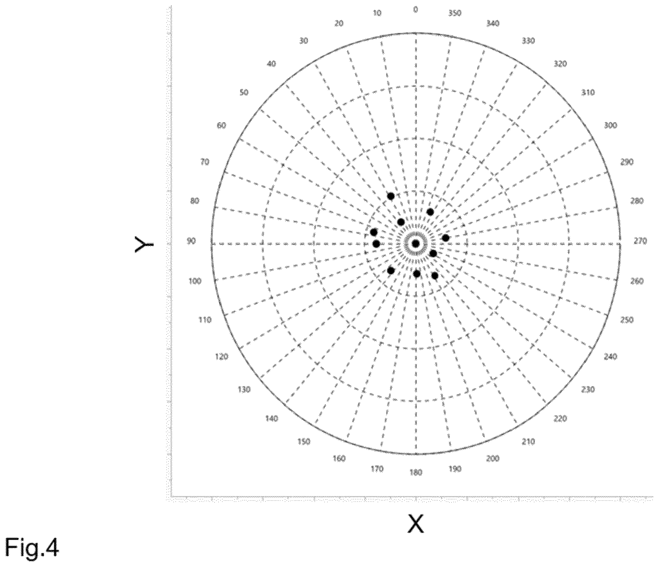

Fig.3 und Fig.4 zeigen für Substratscheiben der ersten Kategorie (Anzahl der seit der letzten Kammerätze vorangegangenen Beschichtungsvorgänge ist null) beziehungsweise für Substratscheiben einer anderen Kategorie (Anzahl der seit der letzten Kammerätze vorangegangener Beschichtungsvorgänge ist 7) gemessene Lageabweichungen in einem Polarkoordinaten-Gitter der mit Bor dotierten Substratscheiben aus einkristallinem Silizium mit einem Durchmesser von 300 mm. Der Vergleich der dargestellten Verteilungen der Lageabweichungen macht deutlich, dass der Betrag der Lageabweichung deutlich ausgeprägter ist, wenn es sich um Substratscheiben der ersten Kategorie handelt, die unmittelbar nach einer Kammerätze beschichtet wurden.

## Patentansprüche

1. Verfahren zum Herstellen von Halbleiterscheiben mit aus der Gasphase abgeschiedener epitaktischer Schicht in einer Abscheidekammer, umfassend das Entfernen von Material aus der Abscheidekammer (3), das sich im Verlauf vorangegangener Beschichtungsvorgänge in der Abscheidekammer (3) niedergeschlagen hat, mittels einer Ätze der Abscheidekammer; nacheinander durchgeführte Beschichtungsvorgänge in der geätzten Abscheidekammer (3), jeweils umfassend das Ablegen einer Substratscheibe (4) auf einem Suszeptor (5) mit kreisförmigem Umfang durch einen Roboter, wobei der Roboter die Substratscheibe in eine Ablageposition bewegt und auf dem Suszeptor (5) ablegt, wobei in der Ablageposition das Zentrum der Substratscheibe wegen einer Korrekturvorgabe nicht über dem Zentrum (10) des Suszeptors liegt; und das Abscheiden einer epitaktischen Schicht auf der Substratscheibe, Substratscheibe (4) wobei eine Halbleiterscheibe mit epitaktischer Schicht entsteht, **dadurch gekennzeichnet, dass** für jede erste Substratscheibe, die nach der Ätze der Abscheidekammer vom Roboter in die Ablageposition bewegt wird, der Betrag der Korrekturvorgabe einem Mittelwert von Lageabweichungen einer Anzahl zuvor beschichteter Substratscheiben entspricht, die selbst jeweils als erste nach einer vorangegangenen Kammerätze beschichtet wurden.

2. Verfahren nach Anspruch 1, **dadurch gekennzeichnet, dass** die Anzahl der zuvor beschichteten Substratscheiben mindestens drei ist.

## Claims

1. Process for producing semiconductor wafers with epitaxial layer deposited from the gas phase in a deposition chamber, comprising
the removal from the deposition chamber (3) of material which has deposited in the deposition chamber (3) in the course of preceding coating operations, by etching of the deposition chamber;
coating operations carried out in succession in the etched deposition chamber (3), in each case comprising the placement of a substrate wafer (4) on a susceptor (5) with circular perimeter by a robot, where the robot moves the substrate wafer into a placement position and places it on the susceptor (5), with a corrective precept causing the center of the substrate wafer not to lie above the center (10) of the susceptor in the placement position; and
the deposition of an epitaxial layer on the substrate wafer, substrate wafer (4), to form a semiconductor wafer with epitaxial layer, **characterized in that**
for each first substrate wafer moved into the placement position by the robot after the etching of the deposition chamber, the amount of the corrective precept corresponds to an average of positional deviations of a number of previously coated substrate wafers themselves each the first to be coated after a preceding chamber etch.

2. Process according to Claim 1, **characterized in that** the number of the previously coated substrate wafers is at least three.

## Revendications

1. Procédé de fabrication de plaquettes de semi-conducteur comprenant une couche épitaxiale, déposée à partir de la phase gazeuse, dans une chambre de dépôt, comprenant le retrait de matériau de la chambre de dépôt (3) qui a été déposé dans la chambre de dépôt (3) au cours d'un processus de revêtement précédent, par attaque chimique de la chambre de dépôt ; des processus de revêtement réalisés successivement dans la chambre de dépôt (3), soumise à une attaque chimique, comprenant chacun la pose, par un robot, d'une plaquette de substrat (4) sur un suscepteur (5) de circonférence circulaire, le robot déplaçant la plaquette de substrat jusque dans une position de pose et la posant sur le suscepteur (5), le centre de la plaquette de substrat n'étant pas situé, dans la position de pose, au-dessus du centre (10) du suscepteur en raison d'une spécification de correction ; et le dépôt d'une couche épitaxiale sur la plaquette de substrat, plaquette de substrat (4), une plaquette de semi-conducteur pourvue d'une couche épitaxiale étant créée, **caractérisé en ce que**, pour chaque première plaquette de substrat qui est déplacée jusque dans la position de pose par le robot après que la chambre de dépôt a été soumise à une attaque chimique, la quantité de spécification de correction correspond à une valeur moyenne d'écarts de position d'un certain nombre de plaquettes de substrat préalablement revêtues qui ont chacune été elle-même revêtue en premier après une attaque chimique précédente de la chambre.

2. Procédé selon la revendication 1, **caractérisé en ce que** le nombre de plaquettes de substrat préalablement revêtues est d'au moins trois.
